# EUROPEAN PATENT APPLICATION

(11) **EP 1 758 152 A2**
(43) Date of publication of application: **28.02.2007**
(21) Application number: 06017632.8
(22) Date of filing: 24.08.2006
(51) Int. Cl.: H01L 21/02, H01G 4/12

(54) **Capacitor and manufacturing method thereof**

(30) Priority: 24.08.2005 JP 2005243238; 18.07.2006 JP 2006195337
(71) Applicant: TOKYO ELECTRON LIMITED, Minato-ku, Tokyo 107-8481 (JP); OCTEC INC., Tokyo 160-0011 (JP); JSR Corporation, Tokyo 104-8410 (JP)
(72) Inventor: Yamanishi, Yoshiki, Amagasaki-shi Hyogo 660-0891 (JP); Harada, Muneo, Amagasaki-shi Hyogo 660-0891 (JP); Kitano, Takahiro, Koshi-shi Kumamoto 861-1116 (JP); Kawaguchi, Tatsuzo, Nirasaki-shi Yamanashi 407-0192 (JP); Hirota, Yoshihiro, Amagasaki-shi Hyogo 660-0891 (JP); Matsuda, Kenji, Amagasaki-shi Hyogo 660-0891 (JP); Yamada, Kinji, Tokyo 104-8410 (JP); Shinoda, Tomotaka, Tokyo 104-8410 (JP); Wang, Daohai, Tokyo 104-8410 (JP); Okumura, Katsuya, Tokyo 160-0011 (JP)
(74) Representative: Liesegang, Eva

(57) **Abstract**

Atmosphere in processing apparatus (100) is adjusted to, for example, oxygen atmosphere, by gas supply source (112) and the like. Interior of thermal processing apparatus (101) is set to oxygen atmosphere and raised to predetermined temperature. A wafer boat (161) containing wafer W having dielectric precursor layer formed is loaded into thermal processing apparatus (101) at speed at which no defects are produced in wafer W. Thereafter, reaction tube of thermal processing apparatus (101) has its internal temperature raised to baking temperature, to perform baking for predetermined time. The wafer W is cooled to predetermined temperature in thermal processing apparatus (101) and then to room temperature in processing apparatus (100), and carried out from processing apparatus (100). Before dielectric precursor layer is baked, it is maintained for predetermined time at temperature higher than temperature at which solvent in dielectric precursor layer is volatilized and lower than temperature at which dielectric precursor layer starts crystallization to vaporize residual solvent.

## Description

The present invention relates to a capacitor and a manufacturing method thereof. Particularly, the present invention relates to a capacitor having a dielectric thin film and a manufacturing method thereof.

Recently, dielectric materials having a high dielectric constant have been used hand in hand with downsizing of capacitors. As a dielectric material having a high dielectric constant, for example, barium titanate having an ABOx-type perovskite structure is used. A barium titanate thin film constituting a capacitor is formed by coating a solution containing materials of barium titanate on a substrate and baking the substrate, as disclosed in, for example, Unexamined Japanese Patent Application KOKAI Publication No. H9-157008.

Since deposition of carbonate, which is caused if carbon dioxide and moisture exist in the furnace at the time of baking, might degenerate the quality of the barium titanate film, it is required to remove carbon dioxide and moisture from the baking atmosphere. Further, if the furnace is preheated when the substrate is carried thereinto, carbon dioxide, moisture, etc. are let into the furnace at the time of carry-in due to the temperature difference between the inside and outside of the furnace, possibly deteriorating the film quality.

Accordingly, in order to prevent degeneration of the film quality due to moisture and carbon dioxide at the time of baking, such a method has been adopted as to carry the substrate into the furnace before the furnace is heated, adjust the atmosphere in the furnace before raising the temperature in the furnace, bake and then cool the substrate in the furnace, and carry the substrate out from the furnace.

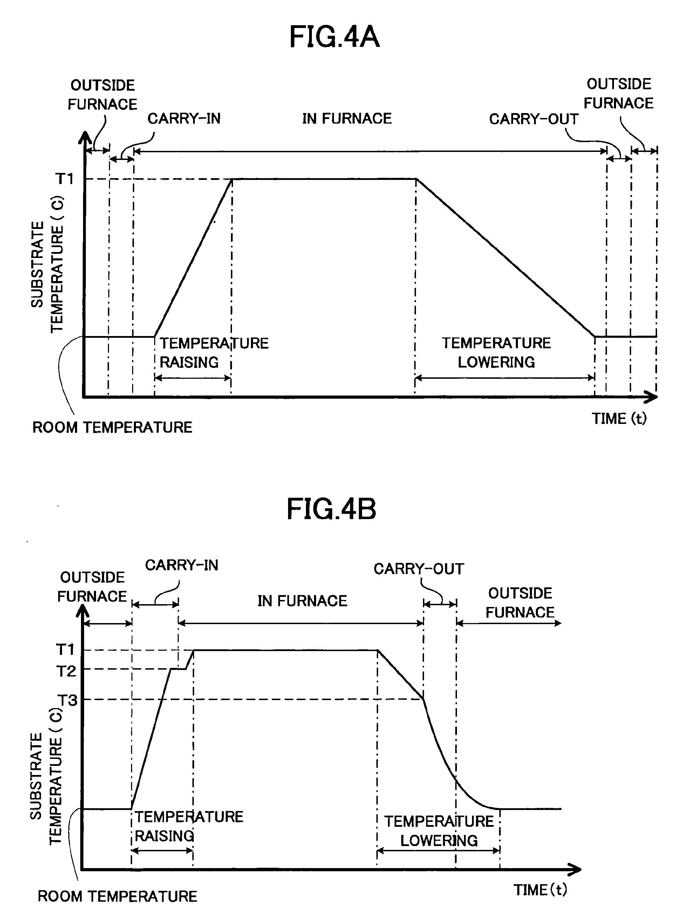

However, according to this method, a temperature raising time during which the temperature in the furnace is raised to a predetermined temperature, a baking time, and a cooling time during which the temperature is cooled to such a level as allowing the substrate to be let out from the furnace are required after the substrate is carried into the furnace, as indicated by the changes of the substrate temperature shown in FIG. 4A. The conventional method has a problem that it requires a long baking time in order to prevent deposition of carbonate and form a dielectric layer having a high quality.

Hence, there is a demand for a manufacturing method of a capacitor which can be formed with a short baking time and has a high quality.

The present invention was made in view of the above-described circumstance, and an object of the present invention is to provide a capacitor which can be formed with a short baking time and has a high quality, and a manufacturing method of the same.

To achieve the above object, a manufacturing method of a capacitor according to a first aspect of the present invention is a manufacturing method of a capacitor including a dielectric layer formed and baked on a first electrode formed on a substrate W and a second electrode formed on the dielectric layer, and comprises: a furnace-interior atmosphere adjusting step of adjusting an atmosphere in a furnace (101); a furnace-exterior atmosphere adjusting step of adjusting an atmosphere outside the furnace (101); a temperature raising step of raising a temperature in the furnace (101) before a substrate W is carried into the furnace (101); a carry-in step of carrying the substrate W on which a dielectric precursor layer is formed into the furnace (101); a baking step of baking the dielectric precursor layer formed on the substrate W to obtain a dielectric layer; a carry-out step of carrying out the substrate W having the baked dielectric layer from the furnace (101); and a cooling step of cooling the substrate W carried out at the carry-out step by exposing the substrate W in the atmosphere outside the furnace (101).

To achieve the above object, a capacitor according to a second aspect of the present invention is manufactured by the manufacturing method of a capacitor according to the first aspect of the present invention.

These objects and other objects and advantages of the present invention will become more apparent upon reading of the following detailed description and the accompanying drawings in which:
FIG. 1 is a diagram showing an example of a structure of a processing apparatus according to an embodiment of the present invention;
FIG. 2 is a diagram showing an example of a structure of a thermal processing apparatus in the processing apparatus shown in FIG. 1;
FIGS. 3A to 3G are cross sectional diagrams for explaining steps of manufacturing a capacitor;
FIG. 4A is a diagram showing temperature changes during a conventional baking process;
FIG. 4B is a diagram showing temperature changes in a case where baking is performed by the processing apparatus shown in FIG. 1;
FIG. 5 is a diagram for explaining the function of an interposer comprising the capacitor according to an embodiment of the present invention;
FIG. 6 is a diagram showing a positional relationship among electrodes of the interposer comprising the capacitor according to an embodiment of the present invention, a circuit substrate, and a semiconductor package;
FIG. 7 is a diagram showing one example of temperature changes during a baking process according to an embodiment 2 of the present invention; and
FIG. 8 is a diagram showing process conditions and evaluations according to the embodiments of the present invention.

A manufacturing method of a capacitor according to an embodiment of the present invention will be explained with reference to the drawings. According to the present embodiment, the explanation will be given by particularly employing a case that a capacitor is mounted on an interposer, as an example.

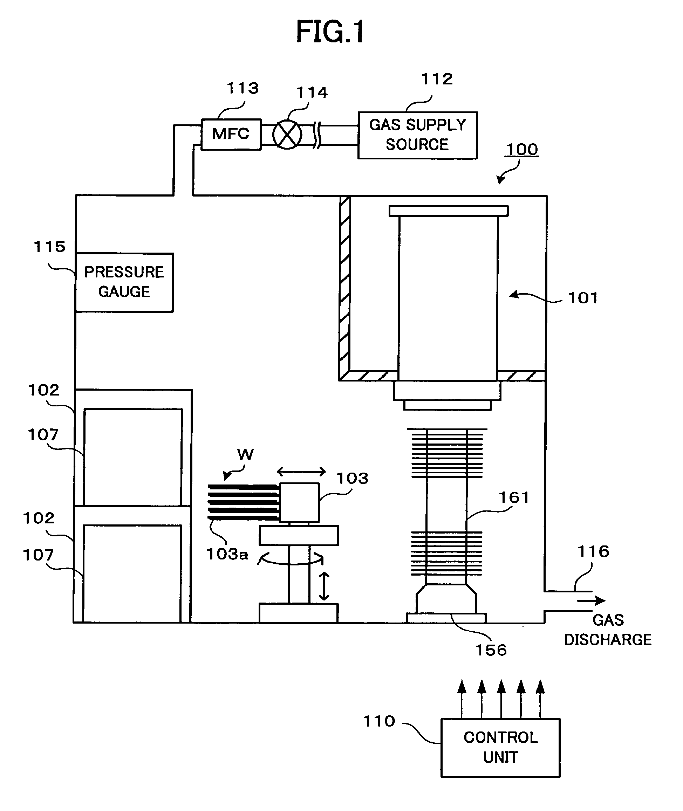

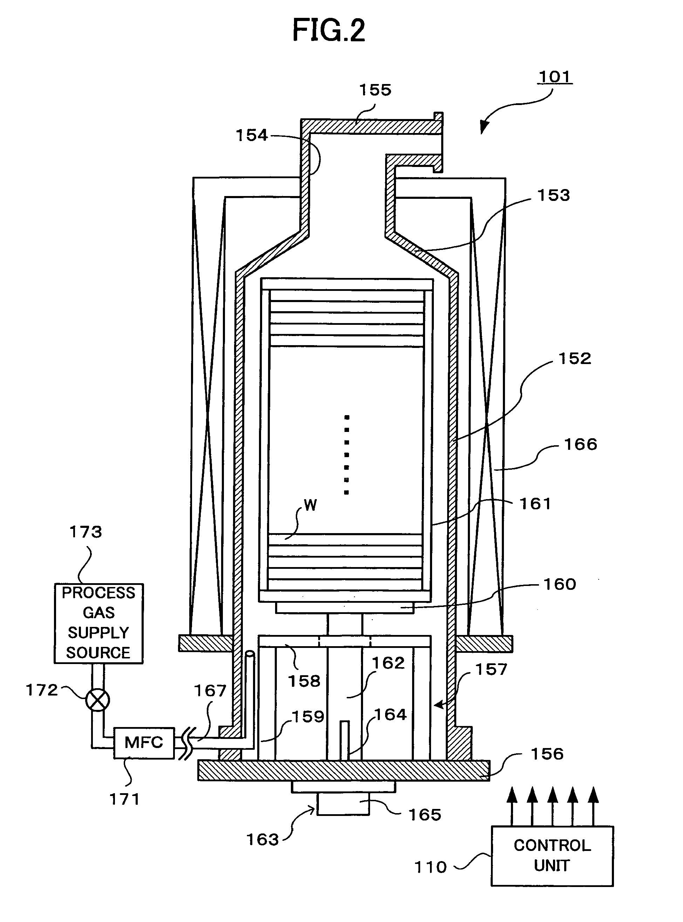

FIG. 1 is a diagram showing an example of the structure of a processing apparatus 100 used in the present embodiment for baking a dielectric layer constituting a capacitor. FIG. 2 is a diagram showing a thermal processing apparatus 101 of the processing apparatus 100 shown in FIG. 1. According to the present embodiment, the explanation will be given by employing a batch-type vertical thermal processing apparatus as an example.

The processing apparatus 100 according to the present embodiment comprises the thermal processing apparatus 101, inlet/outlet chambers 102, a moving mount 103, cassettes 107, a control unit 110, a gas supply source 112, a mass flow controller (hereinafter referred to as MFC) 113, a valve control unit 114, a pressure gauge 115, and a gas discharge duct 116, as shown in FIG. 1.

The inlet/outlet chambers 102 are rooms from which or to which a semiconductor wafer W on which, for example, a dielectric thin film is formed, is carried into or out from the processing apparatus 100. Two inlet/outlet chambers 102 are provided in the vertical direction. The cassette 7 as a container for accommodating semiconductor wafers W is provided in each inlet/outlet chamber 102. The cassette 107 is structured to be capable of accommodating a predetermined number of semiconductor wafers W.

The moving mount 103 is arranged at generally the center of the processing apparatus 100. The moving mount 103 is structured to be able to move in the vertical direction and in the horizontal direction so that it can carry the semiconductor wafer W between the inlet/outlet chambers 102 and the thermal processing apparatus 101, and further structured to be able to rotate. The moving mount 103 is provided with a predetermined number of forks 103a. It is possible to move the semiconductor wafer W to a predetermined position by moving the moving mount 103 while the semiconductor wafer W is placed on the fork 103a.

The control unit 110 comprises a CPU (Central Processing Unit), a RAM (Random Access Memory), a ROM (Read Only Memory), etc., and controls the entire processing apparatus 100. Specifically, the MFC 113, the valve control unit 114, the pressure gauge 115, and an MFC 171, a valve control unit 172, a heater controller (unillustrated), etc. which are included in the thermal processing apparatus 101 to be described in detail later are connected to the control unit 110. The control unit 110 controls the changes in the temperature and the atmosphere in the processing apparatus 100 in the course of the wafer W being carried into the processing apparatus 100 and loaded into a reaction tube 152 of the thermal processing apparatus 101 and the processed wafer W being unloaded and carried out from the thermal processing apparatus 101, and pressure changes, atmosphere, temperature changes, etc. in the reaction tube 152 of the thermal processing apparatus 101.

The gas supply source 112 is constituted by a gas cylinder or the like corresponding to the atmosphere in the processing apparatus 100. According to the present embodiment, barium titanate is used for a dielectric film to be formed on the wafer W. The precursor of barium titanate, if heated in the atmosphere in which moisture and carbon dioxide are present, allows carbonate to be deposited, and the film quality is thus degenerated. Accordingly, an inert gas atmosphere, an oxygen atmosphere, a dried air atmosphere, or the like are preferred as the atmosphere in the processing apparatus 100, and it is particularly preferred that the atmosphere in the processing apparatus 100 be the same atmosphere as that (for example, an oxygen atmosphere) of the thermal processing apparatus 101. In case of an inert gas atmosphere, nitrogen and/or a rare gas are/is used. In case of an oxygen atmosphere, any of oxygen, oxygen plus nitrogen, and oxygen plus a rare gas is used. In any of the cases, a gas cylinder corresponding to the selected atmosphere is prepared. Further, in case of a dried air atmosphere, the gas supply source 12 is provided with a column or the like of a desiccant agent, such as silica gel, so that a dried air is supplied into the processing apparatus 100.

The MFC 113 controls the mass flow of the gas flowing through each duct extending from the gas supply source 112 to an instructed level, and measures the mass flow of the gas actually flowing and notifies the measured value to the control unit 110. The valve control unit 114 is provided on each duct from the gas supply source 112, and controls the opening degree of a valve provided on each duct to the value instructed by the control unit 110. The gas in the processing apparatus 100 is discharged from the gas discharge duct 116. The gas discharge duct 116 is equipped with a valve control unit or the like that is connected to the control unit 110, and adjusts the pressure in the processing apparatus 100 to a predetermined level by adjusting the gas supply amount and gas discharge amount.

As shown in FIG. 2, the thermal processing apparatus 101 comprises a reaction tube 152 having a generally cylindrical shape whose longer dimension extends in the vertical direction. The reaction tube 152 is formed of a material excellent in heat resistance and corrosion resistance, for example, quartz.

The reaction tube 152 has, at its top end, a top 153 having a generally conical shape whose diameter reduces toward the top end. A gas discharge port 154 from which the gas in the reaction tube 152 is discharged is provided at the center of the top 153, and a gas discharge duct 155 is airtightly connected to the gas discharge port 154. The gas discharge duct 155 has an unillustrated pressure adjusting mechanism such as a valve, and controls the interior of the reaction tube 152 to a desired pressure.

A lid 156 is provided at the bottom of the reaction tube 152. The lid 156 is formed of a material excellent in heat resistance and corrosion resistance, for example, quartz. The lid 156 is structured to be capable of being moved upward and downward by a boat elevator (unillustrated) connected to the control unit 110. When the lid 156 is moved upward by the boat elevator in accordance with an instruction from the control unit 110, the bottom (furnace entrance) of the reaction tube 152 is closed as shown in FIG. 2. When the lid 156 is moved downward by the boat elevator, the bottom (furnace entrance) of the reaction tube 152 is opened as shown in FIG. 1.

A heat retention cylinder 157 is provided on the top of the lid 156. The heat retention cylinder 15 mainly comprises a planar heater 158 constituted by a resistance heating element for preventing the temperature in the reaction tube 152 from dropping from about the furnace entrance, and a cylindrical support member 159 which supports the heater 158 at a predetermined height from the top surface of the lid 156.

A rotation table 160 is provided above the heat retention cylinder 157. The rotation table 160 functions as a mounting table on which a wafer boat 161 containing a process target, for example, a wafer W is rotatably mounted. Specifically, a rotation support shaft 162 is provided underneath the rotation table 160. The rotation support shaft 162 is connected to a rotation mechanism 163 which penetrates the center of the heater 158 to cause the rotation table 160 to rotate. The rotation mechanism 163 mainly comprises an unillustrated motor, and a rotation guiding portion 165 having a rotation shaft 164 which is airtightly let through the lower surface to the upper surface of the lid 156. The rotation shaft 164 is jointed to the rotation support shaft 162 of the rotation table 160, and conducts the rotational force of the motor to the rotation table 160 through the rotation support shaft 162. Therefore, when the rotation shaft 164 is rotated by the motor of the rotation mechanism 163, the rotational force of the rotation shaft 164 is transmitted to the rotation support shaft 162 to thereby rotate the rotation table 160.

The wafer boat 161 is structured so as to be capable of containing a plurality of wafers W, for example, 100 wafers, in the vertical direction with a predetermined interval between the wafers. The wafer boat 161 is formed of, for example, quartz. Since the wafer boat 161 is mounted on the rotation table 160, it rotates as the rotation table 160 rotates and the wafers W contained on the wafer boat 161 are rotated.

A temperature raising heater 166 constituted by, for example, a resistance heating element is provided around the reaction tube 152 so as to surround the reaction tube 152. The interior of the reaction tube 152 is heated to a predetermined temperature by the temperature raising heater 166, and the wafer W is consequently heated to a predetermined temperature. The heater 158 and the temperature raising heater 166 are equipped with a heater controller (unillustrated) connected to the control unit 110. In response to an instruction from the control unit 110, the heater controller energizes and heats the heater 158 and the temperature raising heater 166, or measures the power consumed by the heater 158 and the temperature raising heater 166 individually and notifies the measurement results to the control unit 110.

A process gas introduction duct 167 for introducing a process gas into the reaction tube 152 is provided so as to penetrate through the side surface of the reaction tube 152 near the lower end thereof. The process gas introduction duct 167 is connected to a process gas supply source 173 via a mass flow controller (MFC) 171 and a valve control unit 172.

A gas cylinder or the like corresponding to the atmosphere in the reaction tube 152 is set in the process gas supply source 173. According to the present embodiment, barium titanate is used as a dielectric material. The precursor of barium titanate allows carbonate deposition if it is heated in the atmosphere in which moisture and carbon dioxide are present, and carbonate deposition degenerates the film quality. On the other hand, in a case where there is no oxygen when baking is carried out, the barium titanate film will have an oxygen vacancy and lose its quality. Hence, it is preferred that the reaction tube 152 have an oxygen atmosphere inside, and, for example, oxygen and an inert gas (for example, a rare gas such as nitrogen, argon (Ar), etc.) are used. Accordingly, a gas cylinder containing oxygen, nitrogen, argon (Ar), or the like is set in the process gas supply source 173.

The MFC 171 is provided on every duct including the process gas introduction duct 167, etc. controls the mass flow of the gas flowing through each duct to a value instructed by the control unit 110, and measures the mass flow of the gas actually flowing and notifies the measured value to the control unit 110.

The valve control unit 172 is provided on each duct, and controls the opening degree of the valve provided on each duct to a value instructed by the control unit 110.

The thermal processing apparatus 101 comprises a temperature sensor(s) and a pressure gauge(s) which are connected to the control unit 110. The temperature sensor(s) measure(s) the temperature of each component in the reaction tube 152 and in the gas discharge duct 155, and notifies (notify) the measured temperature to the control unit 110. The pressure gauge(s) measure(s) the pressure of each component in the reaction tube 152 and in the gas discharge duct 155, and notifies (notify) the measured pressure to the control unit 110.

Next, a manufacturing method of a capacitor using the processing apparatus 100 having the above-described structure will be explained with reference to the drawings.

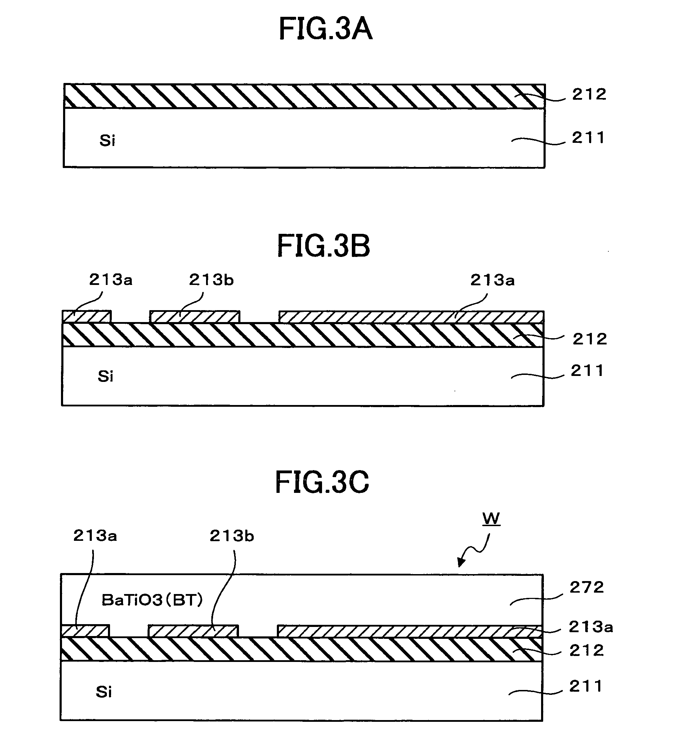

FIG. 3A is a cross sectional view of a substrate on which an oxide film is formed. A substrate 211 formed of, for example, silicon monocrystal is prepared. Then, after stains such as dust adhered on the surface of the substrate 211 are cleaned and removed, the surface of the substrate 211 is oxidized by thermal oxidation, to form an oxide film 212 as shown in FIG. 3A.

FIG. 3B is a cross sectional view of the substrate having an electrode formed on the oxide film. A resist pattern is formed by photolithography or the like, on the regions on the oxide film 212, where a lower electrode 213a and a leading electrode layer 213b are not to be formed, and platinum (Pt) is deposited on the upper surfaces of the resist pattern and oxide film 212 by sputtering, relatively thinly, for example, about 30 nm, to form a platinum layer. Next, the resist pattern is removed by an etching liquid to form the lower electrode 213a and the leading electrode layer 213b on the oxide film 212 as shown in FIG. 3B.

FIG. 3C is a cross sectional view of the substrate having a dielectric layer formed on the electrode. A solution (a substance having an ABOx-type perovskite structure, for example barium titanate) containing a dielectric component is coated on the lower electrode 213a and the leading electrode layer 213b by spin coating to a thickness of, for example, 130 nm, and preliminarily baked for about 1 minute, at a temperature of, for example, 250°C.

A plurality of wafers (substrates) W having undergone preliminary baking are carried into the processing apparatus 100 from the inlet/outlet chamber 102 shown in FIG. 1, and mainly baked. The temperature changes in the substrate at the time of main baking are shown in FIG. 4B.

The wafer (substrate) carried into the inlet/outlet chamber 102 is set on the wafer boat 161 by the moving mount 103. At this time, the atmosphere in the processing apparatus 100 is adjusted to any of an inert gas atmosphere, an oxygen atmosphere, and a dried air atmosphere. The atmosphere in the reaction tube 152 of the thermal processing apparatus 101 is set to an oxygen atmosphere (any of oxygen, oxygen plus nitrogen, and oxygen plus a rare gas). The temperature (T2) in the reaction tube 152 is raised to, for example, 500°C to 800°C. The temperature in the reaction tube 152 is determined to fall within a range of tolerance in which the temperature change rate of the substrate when the substrate is carried into the reaction tube 152 does not produce any defects such as cracks in the substrate and the dielectric precursor layer. At this time, the substrate carry-in speed (the speed at which the wafer boat 161 is loaded) is also adjusted so as not to produce any defects such as cracks in the substrate and the dielectric precursor layer. The substrate carry-in speed at this time is, for example, 10 cm/min.

The wafer boat 161 containing the plurality of wafers W is lifted upward and loaded into the reaction tube 152. After the substrates are carried in and then the temperature of the substrates is once stabilized at T2, the temperature in the reaction tube 152 is raised to a temperature (T1) at which baking is performed, and the dielectric precursor layer is baked in the reaction tube 152 for a predetermined time. At this time, barium titanate constituting the dielectric precursor layer, which has been formed into its amorphous state at the preliminary baking, is formed into a crystal state having an ABOx-type perovskite structure by going through main baking and thereby crystal growth and crystal grain bonding, and thus forms a dielectric layer 272. The dielectric layer 272 has a thickness of, for example, 100 nm.

The substrates are unloaded after the heating of the reaction tube 152 is stopped and the substrates are cooled to a predetermined temperature (T3). At this time, the temperature (T3) targeted by the cooling in the reaction tube 152 and the carry-out speed are adjusted so that the temperature change rate of the substrate may fall within the range of tolerance in which no defects such as cracks are produced in the substrate and the dielectric layer, likewise at the time of carry-in. The substrate carry-out speed at this time is, for example, 10 cm/min. The wafers W are cooled in the processing apparatus 100 until their temperature becomes about a room temperature, and then carried out from the processing apparatus 100. In this manner, the barium titanate layer 272 is formed as shown in FIG. 3C.

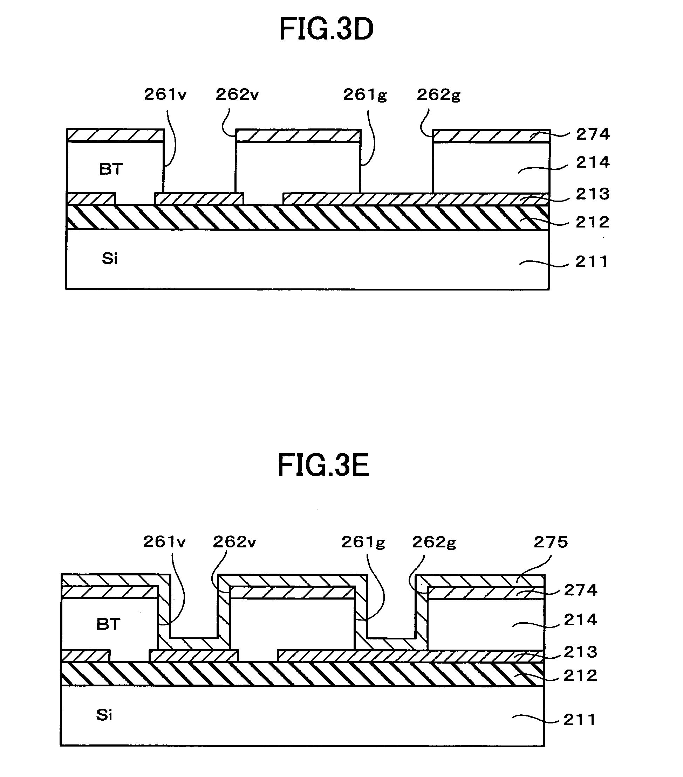

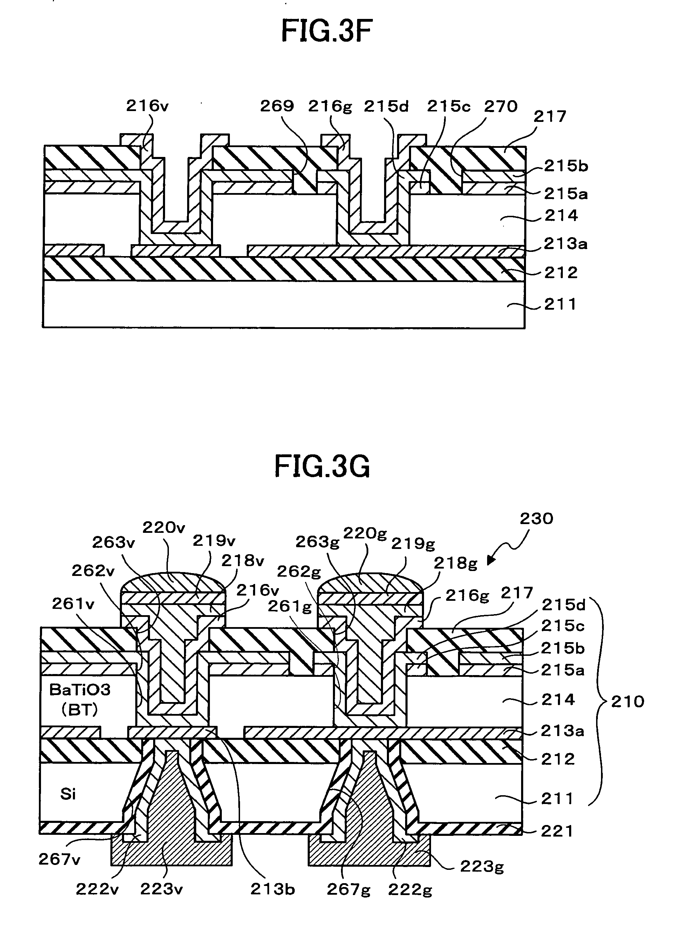

FIG. 3D is a cross sectional view of the substrate having an upper electrode formed on the dielectric layer and opening portions formed. Nickel is deposited on the barium titanate layer 272 by sputtering to form a nickel layer 274. Then, a resist pattern having openings in the regions where a power supply connection conductor Iv and a ground connection conductor Ig are to be formed, is formed on the nickel layer 274 by photolithography or the like. With the resist pattern formed on the nickel layer 274 used as a mask, the regions where electrode pads 218v and 218g shown in FIG. 3G are to be formed are etched out by an etching liquid, to form opening portions 262v and 262g. Then, the resist pattern is removed.

Next, the barium titanate layer 272 exposed in the opening portions is etched out with the nickel layer 274 used as a mask. Thus, as shown in FIG. 3D, a dielectric layer 214 is formed and opening portions 261v and 261g of the dielectric layer 214 are formed to be self-aligned to the opening portions 262v and 262g.

FIG. 3E is a cross sectional view of the substrate having a conductor layer formed in the opening portions of the upper electrode and dielectric layer. Nickel is deposited by sputtering to a thickness of, for example, about 100 nm so as to cover the nickel layer 274 and the entire inner walls of the contact holes (the opening portions 261v, 261 g, 262v, and 262g), to form a nickel layer 275 as shown in FIG. 3E.

FIG. 3F is a cross sectional diagram of the substrate on which a capacitor is formed. After a resist pattern is formed on the nickel layer 275 by photolithography or the like, etching is performed by using the resist pattern as a mask to form an opening portion 269 and an opening portion 270. As a result, upper electrodes 215a and 215b and upper electrodes 215c and 215d are formed as shown in FIG. 3F.

The resist pattern is removed, and an insulating film 217 is formed on the upper electrodes 215b and 215d and to fill the opening portions 269 and 270. Next, nickel is deposited by sputtering on an opening portion 263v of the insulating film 217, on the upper electrode 215b exposed in the opening portion 263v, on an opening portion 263g of the insulating film 217, on the upper electrode 215d exposed in the opening portion 263g, and on the insulating film 217, and then patterned, there by to form metal films 216v and 216g.

FIG. 3G is a cross sectional view of an interposer on which electrode pads are formed. Electrode pads 218v and 218g are formed by plating. The electrode pad 218v is formed so as to fill the opening portion 263v, and the electrode pad 218g is formed so as to fill the opening portion 263g. Then, metal layers 219v and 219g formed of gold (Au) are formed by plating on the electrode pads 218v and 218g respectively. Solder layers are formed on the metal layers 219v and 219g respectively, to form bumps 220v and 220g.

Next, electrode pads 223v and 223g are formed in the lower surface of the substrate 211 in order to complete an interposer 230. A resist pattern is formed so as to correspond to the regions on the lower surface of the substrate 211 where the electrode pads 223v and 223g are to be formed. With the resist pattern used as a mask, opening portions 267v and 267g having, for example, a generally quadrangular pyramid shape, are formed by etching.

An insulating layer 221 is formed so as to cover the surfaces of the opening portions 267v and 267g and the lower surface of the substrate 211. Then, metal layers 222v and 222g formed of nickel are formed by sputtering or the like on the insulating layer 221 formed on the opening portions 267v and 267g. Then, the electrode pads 223v and 223g formed of, for example, copper are formed on the metal layers 222v and 222g by plating or the like.

The interposer 230 having the capacitor 210 is manufactured as shown in FIG. 3G, through the above-described steps.

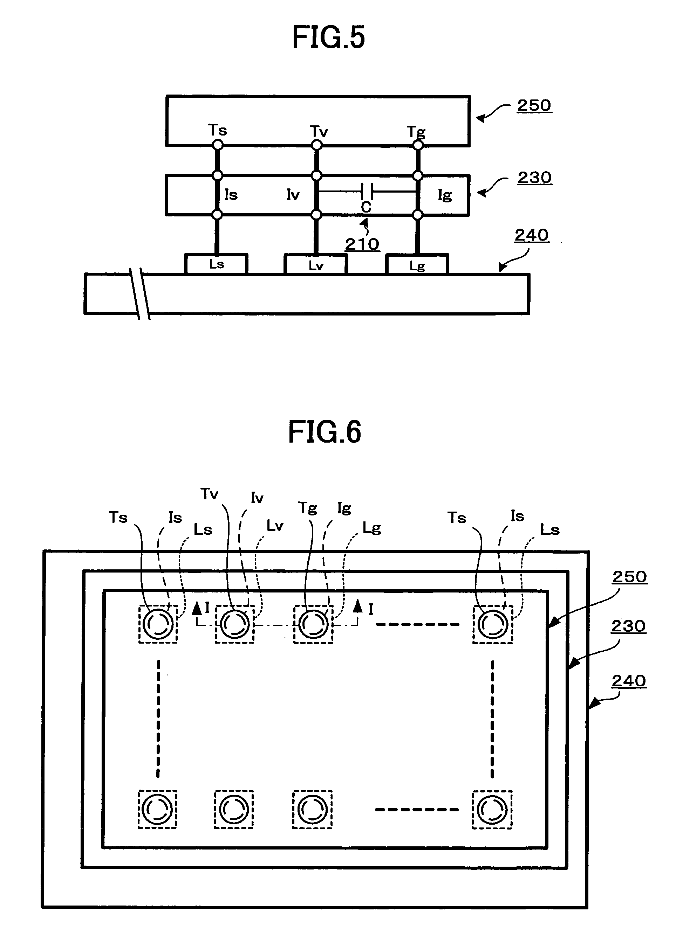

FIG. 5 is a diagram for explaining the function of an interposer having a capacitor. FIG. 6 is a diagram showing a positional relationship among electrodes of an interposer, a circuit substrate, and a semiconductor package. The interposer 230 shown in FIG. 3G corresponds to a cross sectional view as sectioned along a line I-I shown in FIG. 6. Further, as exemplarily shown in FIG. 5, the interposer 230 is a device which is disposed between a semiconductor package (chip) 250 and a circuit substrate 240, connects a power supply terminal Tv, a ground terminal Tg, and a plurality of signal terminals Ts of the semiconductor package 250 to a power supply line Lv, a ground line Lg, and a plurality of signal lines Ls of the circuit substrate 240 by connection conductor Iv, Ig, and Is respectively, and connects a capacitor C (capacitor 210) for reducing power supply noises between the power supply terminal Tv and ground terminal Tg of the semiconductor substrate 250.

As exemplarily shown in FIG. 6 by a plan view, the connection terminals of the semiconductor package 250, the upper and lower connection terminals of the interposer 230, and connection pads of the lines of the circuit substrate 240 are arranged at the same positions comparatively. The connection terminals of the semiconductor package 250 and the corresponding connection pads of the circuit substrate 240 are connected via the interposer 230, when their horizontal positions are matched to overlay the corresponding terminals. A sealing member such as a resin or the like is filled in the space between the circuit substrate 240 and the interposer 230, and in the space between interposer 230 and the semiconductor package 250, where needed.

As described above, according to the manufacturing method of a capacitor of the present embodiment, when the dielectric film 214 is formed, not only the atmosphere in the thermal processing apparatus 101 but also the atmosphere in the processing apparatus 100 (outside the thermal processing apparatus 101) are deprived of moisture and carbon dioxide, and preferably, they are adjusted to the same atmosphere as each other. Accordingly, the time conventionally required for raising the temperature from a room temperature to a baking temperature can be omitted. Further, since the substrate can be carried out from the reaction tube 152 even if the substrate maintains a high temperature, it can be cooled in an atmosphere having a room temperature, unlike the conventional method in which the substrate is cooled in the reaction tube 152, making it possible to greatly shorten the cooling time. Further, since the atmospheres inside and outside the thermal processing apparatus 101 are adjusted, the dielectric film 214 can be prevented from degeneration of its film quality and the dielectric film 214 having a high quality can be formed. As explained above, according to the manufacturing method of the present embodiment, a capacitor comprising a dielectric layer having a high quality can be manufactured in a short manufacturing time.

Furthermore, in a case where, like the present embodiment, preliminary baking takes 1 minute while main baking takes 60 minutes and there is a difference in the time required by the respective processes, since, according to the present embodiment, wafers can be collectively subjected to main baking after preliminary baking is performed plural times wafer by wafer, the manufacturing efficiency is excellent unlike the conventional manufacturing method in which a sputtering process and a thermal process are performed wafer by wafer.

Next, an embodiment 2 in which baking of a dielectric layer is performed at a different step will be explained. The embodiment 2 comprises a step of vaporizing a solvent remaining in a dielectric layer before the step of baking the dielectric layer. The embodiment 2 is the same as the embodiment 1 in the other respects.

According to the embodiment 2, likewise the embodiment 1, a solution (a substance having an ABOx-type perovskite structure, for example, barium titanate) containing a dielectric component is coated by spin coating to a thickness of, for example, 130 nm on the lower electrode 213a and leading electrode layer 213b formed on the oxide film 212, and preliminarily baked for about 1 minute at a temperature of, for example, 250°C.

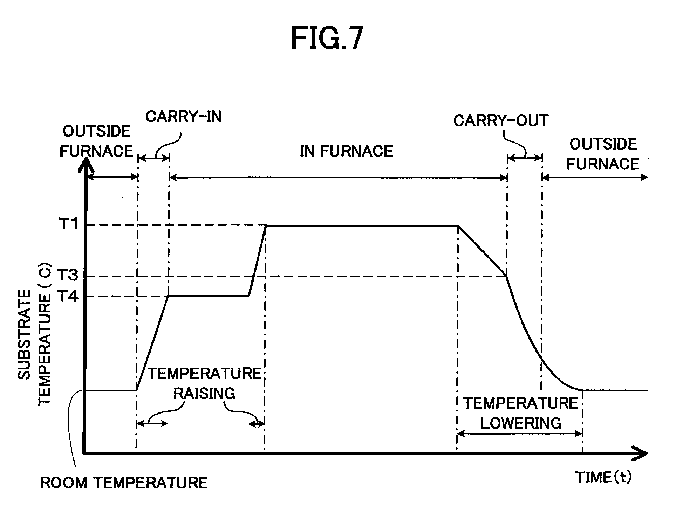

A plurality of wafers (substrates) W having undergone preliminary baking are carried into the processing apparatus 100 from the inlet/outlet chamber 102 and mainly baked. FIG. 7 shows one example temperature changes during the baking process in the embodiment 2.

The wafers (substrates) carried into the inlet/outlet chamber 102 are set on the wafer boat 161 by the moving mount 103. At this time, the atmosphere in the processing apparatus 100 is adjusted to any of an inert gas atmosphere, an oxygen atmosphere, a dried air atmosphere. The atmosphere in the reaction tube 152 of the thermal processing apparatus 101 is set to an oxygen atmosphere (any of oxygen, oxygen plus nitrogen, and oxygen plus a rare gas). The temperature (T4) in the reaction tube 152 is raised to, for example, 400°C to 600°C. The temperature (T4) in the reaction tube 152 is set to a temperature which is higher than a temperature at which the solvent in the solution containing the dielectric component is volatilized, and which is lower than a temperature at which the dielectric substance starts crystallization. Such a temperature generally exists in a range of tolerance in which the temperature change rate of the substrate when the substrate is carried into the reaction tube 152 does not produce any defects such as cracks in the substrate and the dielectric precursor layer. Furthermore, the substrate carry-in speed (the speed at which the wafer boat 161 is loaded) is also adjusted so as not to product any defects such as cracks. At this time, the substrate carry-in speed is, for example, 10 cm/min.

The wafer boat 161 containing the plurality of wafers W is lifted upward and loaded in the reaction tube 152. After the substrates are carried in, the temperature in the reaction tube 152 is maintained at T4 for a predetermined time (hereinafter, referred to as high preliminary baking). Since the temperature T4 is higher than the temperature at which the solvent is volatilized and lower than the temperature at which the dielectric substance starts crystallization, the organic solvent remaining after preliminary baking is not confined in the dielectric layer but completely vaporized if the time during which the temperature is maintained at T4 is set appropriately. As a result, no carbon originating from organic solvent remains in the dielectric thin film after main baking, and the electric property of the dielectric thin film can be improved. The predetermined time secured for the high preliminary baking for vaporizing the residual solvent in the dielectric layer is, for example, 10 to 30 minutes.

After this, the temperature is raised to a main baking temperature (T1), and the dielectric precursor layer is baked in the reaction tube 152 for a predetermined time. At this time, barium titanate constituting the dielectric precursor layer, which has been formed into its amorphous state at the preliminary baking, is formed into a crystal state having an ABOx-type perovskite structure by going through main baking and thereby crystal growth and crystal grain bonding, and thus forms a dielectric layer 272. The dielectric layer 272 has a thickness of, for example, 100 nm.

The substrates are unloaded after the heating of the reaction tube 152 is stopped and the substrates are cooled to a predetermined temperature (T3). Likewise in the embodiment 1, the temperature (T3) targeted by the cooling in the reaction tube 152 and the carry-out speed are adjusted so that the temperature change rate of the substrate may fall within the range of tolerance in which no defects such as cracks are produced in the substrate and the dielectric layer. The substrate carry-out speed is, for example, 10 cm/min. The wafers W are cooled in the processing apparatus 100 until their temperature becomes about a room temperature, and then carried out from the processing apparatus 100. In this manner, the barium titanate layer 272 is formed as shown in FIG. 3C. Since the steps after the formation of the dielectric layer 214 are the same as those in the embodiment 1, explanation of these steps will be omitted.

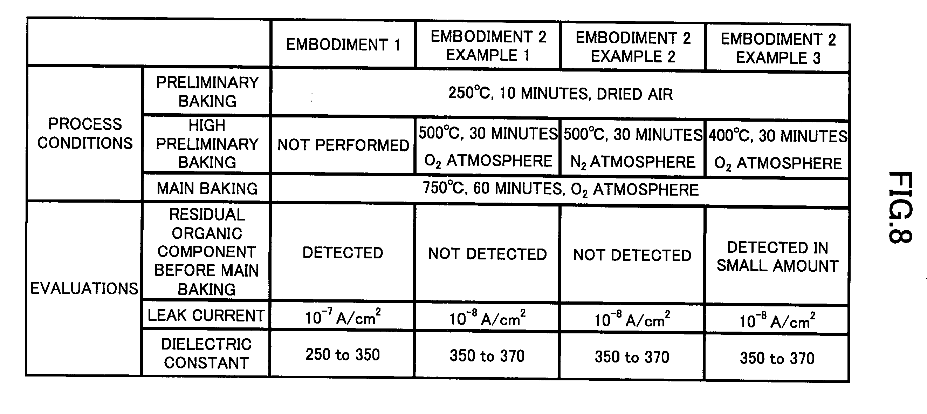

FIG. 8 shows examples of process conditions and evaluations, concerning the respective cases where the manufacturing methods of the embodiment 1 and embodiment 2 were used. The substance used for forming the dielectric layer contained, as the dielectric component, both of (i) and (ii) or either (i) or (ii), where (i) includes particles having an ABOx-type crystal structure, (ii) includes at least one component selected from the group consisting of metal alkoxide, metal carboxylate, metal complex, and metal hydroxide each of which contains metal species A and metal species B. The concentration of the oxide particles was 20 to 3 wt%, and preferably 12 to 3 wt%. As the organic solvent, for example, alcohol solvent, polyalcohol solvent, ether solvent, ketone alcohol, ester solvent, or the like was used. In the examples shown in FIG. 8, 2-methoxyethanol was used.

In the examples shown in FIG. 8, as the embodiment 2, high preliminary baking for vaporizing the residual solvent was performed in an oxygen atmosphere (example 1 and example 3), or in a nitrogen atmosphere (example 2) at a temperature of 400°C (example 3) or 500°C (example 1 and example 2) for 30 minutes. Since the temperature at which crystallization starts is 600°C or higher, high preliminary baking was performed at lower than 600°C. The other conditions were the same between the embodiment 1 and the embodiment 2. 2-methoxyethanol as the solvent has a boiling point of 124.5°C and an ignition point of 285°C. Preliminary baking was performed at a temperature equal to or higher than the boiling point and equal to or lower than the ignition point. In the examples shown in FIG. 8, preliminary baking was performed in a dried air atmosphere at a temperature of 250°C for 10 minutes. Main baking was performed in an oxygen atmosphere at a temperature of 750°C for 60 minutes.

As shown in FIG. 8, in the example according to the embodiment 1, a residual organic component was detected before main baking, while in the examples 1 and 2 according to the embodiment 2, no residual organic component was detected. In preliminary baking, the coated solution was dried but the organic component remained. The leak current observed from the capacitor 210 manufactured according to the embodiment 2 had a value smaller by one figure than the value observed according to the embodiment 1. In the example according to the embodiment 1, the dielectric constant of the dielectric layer 214 ranged from 250 to 350 with sample-by-sample variations, while in the examples according to the embodiment 2, a stable result was obtained with sample-by-sample variations falling within a small range of 350 to 370. High preliminary baking was performed in an N₂ atmosphere in the example 2, and resulted in the same outcome as the example 1 in which high preliminary baking was performed in an O₂ atmosphere. In the case where high preliminary baking was performed at a temperature of 400°C, an organic component of a small amount was detected though the leak current and the dielectric constant had the same values. Therefore, it is preferred that high preliminary baking be performed at a temperature of 500°C or hither.

As explained above, if high preliminary baking shown in the embodiment 2 is performed before main baking, the properties of the capacitor are further stabled, and a capacitor having a high quality can be manufactured. Since high preliminary baking is intended to completely vaporize the organic solvent, it may be performed in the same atmosphere as preliminary baking. In a case where high preliminary baking is performed in the same atmosphere as main baking, it is possible to shorten the time required for the baking step since main baking can be performed continuously after high preliminary baking.

The present invention is not limited to the above described embodiments, but can be modified and applied in various manners.

For example, according to the above-described embodiments, the explanation has been given by employing a case that barium titanate is used as a ferroelectric substance. However, this is not the only case. In a case where a substance other than barium titanate is used, the atmosphere in the processing apparatus 100 and the atmosphere in the thermal processing apparatus 101 are adjusted appropriately in accordance with the substance used. Further, the temperature and time for high preliminary baking are adjusted in accordance with the substance and solvent to be used, film thickness, etc. The values indicated in the above-described embodiments are mere examples, and not the only ones.

The embodiments disclosed herein should be considered to be illustrative in every respect but not to be restrictive. The scope of the present invention is shown by the claims, not by the description given above, and intended to include every modification made within the meaning and scope equivalent to the claims.

Various embodiments and changes may be made thereunto without departing from the broad spirit and scope of the invention. The above-described embodiments are intended to illustrate the present invention, not to limit the scope of the present invention. The scope of the present invention is shown by the attached claims rather than the embodiments. Various modifications made within the meaning of an equivalent of the claims of the invention and within the claims are to be regarded to be in the scope of the present invention.

## Claims

1. A manufacturing method of a capacitor including a dielectric layer formed and baked on a first electrode formed on a substrate W, and a second electrode formed on said dielectric layer, said method **characterized by** comprising:
a furnace-interior atmosphere adjusting step of adjusting an atmosphere in a furnace (101);
a furnace-exterior atmosphere adjusting step of adjusting an atmosphere outside said furnace (101);
a temperature raising step of raising a temperature in said furnace (101) before a substrate W is carried into said furnace (101);
a carry-in step of carrying said substrate W on which a dielectric precursor layer is formed into said furnace (101);
a baking step of baking said dielectric precursor layer formed on said substrate W to obtain a dielectric layer;
a carry-out step of carrying out said substrate W having said baked dielectric layer from said furnace (101); and
a cooling step of cooling said substrate W carried out at said carry-out step by exposing said substrate W in the atmosphere outside said furnace (101).

2. The manufacturing method of a capacitor according to claim 1,
**characterized in that** at said furnace-interior atmosphere adjusting step, the atmosphere in said furnace (101) is any of oxygen, oxygen plus nitrogen, and oxygen plus a rare gas.

3. The manufacturing method of a capacitor according to claim 1 or 2,
**characterized in that** at said furnace-exterior atmosphere adjusting step, the atmosphere outside said furnace (101) is any of an inert gas atmosphere formed by either nitrogen or a rare gas, an oxygen gas atmosphere formed by any of oxygen, oxygen plus nitrogen, and oxygen plus a rare gas, and a dried air atmosphere.

4. The manufacturing method of a capacitor according to one of the preceding claims,
**characterized in that** the atmosphere in said furnace (101) and the atmosphere outside said furnace (101) are same as each other.

5. The manufacturing method of a capacitor according to one of the preceding claims,
**characterized in that** at said carry-in step, a speed at which said substrate W is carried in is adjusted such that a temperature change rate of said substrate W falls within a predetermined range in which no defects are produced in said substrate W and said dielectric precursor layer.

6. The manufacturing method of a capacitor according to one of the preceding claims,
**characterized in that** at said carry-out step, a speed at which said substrate W is carried out is adjusted such that a temperature change rate of said substrate W falls within a predetermined range in which no defects are produced in said substrate W and said baked dielectric layer.

7. The manufacturing method of a capacitor according to one of the preceding claims,
**characterized in that** at said temperature raising step, the temperature in said furnace (101) is raised to 500°C to 800°C.

8. The manufacturing method of a capacitor according to one of the preceding claims,
**characterized in that** said dielectric layer is formed by a sol-gel method.

9. The manufacturing method of a capacitor according to one of claims 1 to 7, **characterized in that** said dielectric layer has an ABOx-type perovskite structure.

10. The manufacturing method of a capacitor according to one of the preceding claims,
**characterized in that** said baking step includes a residual solvent vaporizing step of maintaining said dielectric precursor layer formed on said substrate W at a temperature which is higher than a temperature at which a solvent included in said dielectric precursor layer is volatilized and lower than a temperature at which said dielectric precursor layer starts crystallization, for a predetermined time before said dielectric precursor layer is baked.

11. The manufacturing method of a capacitor according to claim 10, **characterized in that** at said temperature raising step, the temperature in said furnace (101) is raised to the temperature which is higher than the temperature at which said solvent included in said dielectric precursor layer is volatilized and lower than the temperature at which said dielectric precursor layer starts crystallization.

12. A capacitor manufactured by said manufacturing method of a capacitor according to one of the preceding claims.
